# EUROPEAN PATENT APPLICATION

(11) **EP 2 242 094 A1**
(43) Date of publication of application: **20.10.2010**
(21) Application number: 09100238.6
(22) Date of filing: 17.04.2009
(51) Int. Cl.: H01L 21/60, H01L 23/498, H01L 23/495, H01L 21/48

(54) **Foil and method for foil-based bonding and resulting package**

(71) Applicant: NXP B.V., 5656 AG Eindhoven (NL)
(72) Inventor: Peels, W, Redhill, Surrey RH1 1DL (GB); Bosch, Johannes, Redhill, Surrey RH1 1DL (GB)
(74) Representative: Williamson, Paul Lewis

(57) **Abstract**

The present invention relates to a package (1) in which a semiconductor device is bonded by foil-based bonding, in particular by foil-based clip- and/or wire-bonding of, comprising a die (2) attached to a first carrier (4) with its first side (6), and attached with its second side (8) to a second carrier (9, 9a, 10), the second carrier comprising a foil (9, 9a, 10) for foil-based bonding, in particular for foil-based clip- and/or wire-bonding of a semiconductor device, and the first (4) and second (9, 9a, 10) carrier are mutually connected, such that a thermal and/or electrical current may flow from the second side (8) of the die (2) to any pad (11) in the first carrier (4), whereas the die (2) and the first (4) and the second (9, 9a, 10) carrier are encapsulated at least partially, **characterized in that** the foil (9, 9a, 10) is a foil (9, 9a, 10) for foil-based bonding, in particular for foil-based clip- and/or wire-bonding of a semiconductor device, comprising an insulating material (9a) containing at least one conductive structure (10), whereas the conductive structure (10) comprises at least three sections (10a, 10b, 10c, 10d) with mutually different spatial orientations.

## Description

### FIELD OF THE INVENTION

The present invention relates to a method and foil for foil-based bonding, in particular for foil-based clip- and/or wire-bonding of a semiconductor device, and to a resulting package.

### BACKGROUND OF THE INVENTION

Semiconductor devices can be connected by clip-bonding or by wire-bonding. Particularly for discrete or semi-discrete power semiconductor devices conventional wire bonds are not appropriate anymore due to the limited power capacity. Accordingly in the field of bonding of semiconductor devices the wire-bonds were partly replaced by clip-bonding.

From WO 2004/03223 A1 a clip-bonding on the basis of two lead frames, the so called LFPAK design, is known. From WO 1996/036071 A2 a SMD diode package with conductive strips is known. From WO 2004/57662 A2 it is known a package with an additional foil on its top side for interconnect purposes. The foil can be an insulating foil, a gauze or a foil with an additional sacrificial layer. In addition to the chip, an additional connection element is present in such a package. The connection element of this prior art can be a piece of silicon but also a mere metal or solder ball. From WO 2003/85736 A2 a package is known which is made by assembling a body having a chip in a cavity with a cover foil including an additional sacrificial layer. In this prior art molding material is applied before removal of the sacrificial layer from the cover foil. In this prior art the chip may also be attached to the planar cover foil. From this prior art it is further known to use a deformed foil with a thermally conductive layer. From WO2007/052199 it is known a clip that is attached to a sacrificial layer which is removed subseqently.

To make the technical background complete also alternative manufacturing techniques for wire-bonding should be mentioned. For example, in the 1980s the technique of tape automated bonding (TAB) was developed which used a carrier with partially flying tracks or wires. With other words, the carrier was reduced to a plurality of strips. In this prior art, at the areas of the contact pads, both on the chip and on a board, the carrier was not present.

More prior art in this field of bonding of semiconductor devices is disclosed in US 6569764 B1, JP 11186492 A, US 4792532 A, US 2003/0197278 A1, US 2005/0151235 A1, US 2004/0063240 A1, EP 1 111 672 A2, and from US 2004/0169289 A1.

### SUMMARY OF THE INVENTION

It is an object of the present invention to provide improved foil-based bonding. In a first aspect of the present invention it is provided a foil for foil-based bonding, in particular for foil-based clip- and/or wire-bonding of a semiconductor device, comprising an insulating material containing at least one conductive structure, whereas the conductive structure comprises at least three sections with mutually different spatial orientations.

In a further aspect of the present invention it is provided a method for foil-based bonding, in particular for foil-based clip- and/or wire-bonding of a semiconductor device, comprising the steps of:
- using a foil for foil-based bonding, in particular for foil-based clip- and/or wire-bonding of a semiconductor device, the foil comprising an insulating material containing at least one conductive structure, and
providing the conductive structure with at least three sections with mutually different spatial orientations.

In a further aspect of the present invention it is provided a package in which a semiconductor device is bonded by foil-based bonding, in particular by foil-based clip- and/or wire-bonding of, comprising a die attached to a first carrier with its first side, and attached with its second side to a second carrier, the second carrier comprising a foil for foil-based bonding, in particular for foil-based clip- and/or wire-bonding of a semiconductor device, and the first and second carrier are mutually connected, such that a thermal and/or electrical current may flow from the second side of the die to any pad in the first carrier, whereas the die and the first and the second carrier are encapsulated at least partially, **characterized in that** the foil is a foil for foil-based bonding, in particular for foil-based clip- and/or wire-bonding of a semiconductor device, comprising an insulating material containing at least one conductive structure, whereas the conductive structure comprises at least three sections with mutually different spatial orientations.

Preferred embodiments of the invention are defined in the dependent claims.

The present invention comprises the perception that the concepts with an additional sacrificial layer as for example disclosed in WO2007/052199 have as a disadvantage that the base foils have a limited industrial availability and as a consequence they are expensive. Etching of one metal on top of a second metal requires special etchants which are not readily available in the market. The tear strength of a metal foil and particular of aluminum is low which can easily give loose parts in cutting and bending. The sacrificial layers have to be removed by etching after soldering. Compatibility of the die with these etching fluids is very doubtful so that long term corrosion problems are to be expected.

It is moreover an insight of the present invention that the aforementioned industrialized concepts, such as LFPAK, have the disadvantage that the multiplicity is limited and that the second lead frame has to be big. This means not only that a lot of material is wasted but also that the number of products per frame is limited. Moreover, the ratio of package size and chip size is relatively large. Additionally product changes require a completely new package design. Also the aforementioned TAB foil has the disadvantage that it has been in use in combination with thermo compression bonding for the connection between TAB foil and on-chip contact pads and an epoxy glob top compound. The thermo compression bonding appears necessary in order to prevent release of said connection in a further soldering operation, particularly that between the TAB foil and a board. The glob top is needed instead of the transfer molding that is nowadays standard in integrated circuit (IC) manufacturing, in order to prevent damage to the individual flying wires on the TAB foil. The aforementioned concept of WO 2004/57662 A2 has the limitation that it is not industrialized. It might be suitably made on a single scale but volume manufacturing is more problematic. Moreover, the use of an additional connection element in the form of a die is expensive. A similar limitation is present in relation to the concept as disclosed in WO 2003/85736 A2.

Embodiments of the present invention comprising or using a lamellar conductive structure or pattern provide the advantage that, in particular if used within a frame, they allow doing the following large scale manufacturing steps:
- Deforming step per lamella/strip;
- Assembling second carrier to first carrier, with the chips attached either the first carrier or to the second carrier, preferably to the first carrier;
- Soldering in one step the conductive patterns both to on-chip contact pads and to contact pads of the first carrier;
- Molding the assembly of first and second carrier, such that the molding compound enters any space between said first and second carrier through the access holes in the second carrier, and through spaces between neighbouring strips;
- Dicing the assembly into individual components or strips of individual components.

Further embodiments are as follows:
The deforming is suitably done such that a conductive pattern is subdivided into three sections with mutually different orientations to at least keep away the conductive pattern from an edge of a die of the semiconductor device. Preferably this is provided by using at least one of the following features:
   (a) a first section on top of the on-chip contact pad (parallel to substrate)
   (b) a second section extending away from the substrate (upwards, with an angle of between 15 and 45 degrees, preferably between 20 and 45 degrees, more preferably about 41 degrees, with respect to substrate)
   (c) a third section extending on the 1st carrier's contact pad, and making an angle thereto of between 20 and 60 degrees, preferably between 25 and 50 degrees, more preferably between 29 and 32 degrees, (and including an angle between 80 and 150 degrees, preferably between 90 and 140 degrees, with respect to the second section).This embodiment (with an upward section) has following major advantages:
      - the conductive pattern is kept away from the edge of the chip, preventing undesired artefacts (in power packages of specific design: preventing short-circuitry between gate electrode, that circumferes the source electrode to which one conductive pattern is coupled), and allowing a proper encapsulation of the pattern into the mould.
      - the angle of the third section is optimal for a proper solder bonding; the solder joint is less sensitive for wear out
      - generally, due to the angle, the shape of the conductive pattern appear defined better.
The insulating material of the second carrier is suitably a polyimide tape such as in use for Tape BGA packages. This is commercially available and is able to withstand soldering conditions. Preferably a so-called adhesiveless copper-polyimide laminate is used.
The copper can be single layer or double layer with a separation layer in between. In the latter case the polyamide and part of the copper can be peeled off after soldering.
The first carrier is suitably a TULIP frame (in comparison to f.i. a HVQFN leadframe). This TULIP frame does not have any foil that is not compatible with the soldering process directly thereon (although this problem may have been solved in the development leading to the double flip chip HVQFN for Caen.)

Suitably, the conductive patterns of the second carrier are provided with an adhesion layer for solder. Such may be a noble metal (eg NiAu, NiPd and the like), but alternatively an OSP (Organic Solder Preservative) as is known in the art per se.

The second carrier may be provided with conductive patterns on both sides, and contacts between the patterns on both sides. Also, the insulating material may be locally removed to expose the conductive pattern partially from the remote side. This embodiment can also be achieved with commercially available tapes. Its advantage is that it may be used for stacked die packages. Optimal process flows are to be elaborated further.

It is not necessary that all conductive patterns of the second carrier provide connections between the chip and the first carrier. Some may be operating as interconnects between a first and a second chip. Some may be defined in appropriate shape to constitute an inductor.

The conductive patterns should be of sufficient size and thickness to carry the power to/from the package.

Clip bonding should be done to both source and gate in one step, and even when the gate size is down to 300um and below.

Multiple die sizes can be provided for a specific clip / lead frame combination, only limited by the size of the die attach pad.

Dual packages can be provided, and higher multiplicities, electrically interconnected by a flex-pcb, whereas the one package might contain a sensor and the other an ASIC.

Packages can be provided, where a protruding flex-pcb makes the electrical interconnect to the outside world and where the lead frame is used for cooling.

### DETAILED DESCRIPTION OF THE INVENTION

The present invention is further elucidated by the following figures and examples, which are not intended to limit the scope of the invention. The person skilled in the art will understand that various embodiments may be combined.

### BRIEF DESCRIPTION OF THE DRAWINGS

These and other aspects of the invention will be apparent from and elucidated with reference to the embodiment(s) described hereinafter. In the following drawings
Fig. 1 shows a schematic side view of an embodiment of the present invention, and
Fig. 2 shows a schematic top view on the embodiment of the present invention according to Fig.1.

### DETAILED DESCRIPTION OF THE DRAWINGS

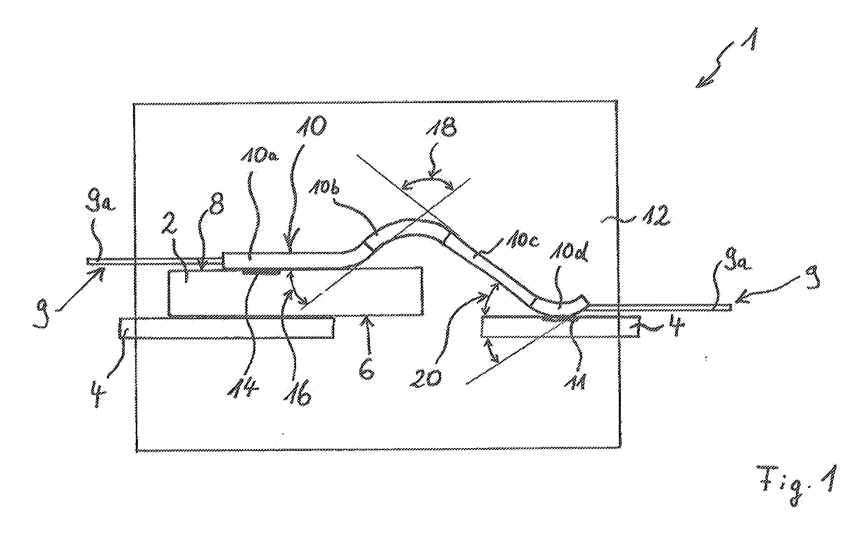

Fig. 1 shows a semiconductor package 1 in which a semiconductor device is bonded by foil-based bonding, the semiconductor device comprising a die 2 attached to a first carrier 4 with its first side 6, and attached with its second side 8 to a second carrier, the second carrier comprising a foil 9 for foil-based bonding, and the first carrier 4 and the second carrier 9 are mutually connected, such that a thermal and/or electrical current may flow from the second side 8 of the die 2 to a pad 11 in the first carrier 4, whereas the die 2 and the first 4 and the second 9 carrier are encapsulated at least partially by a mold 12 to form the semiconductor package 1.

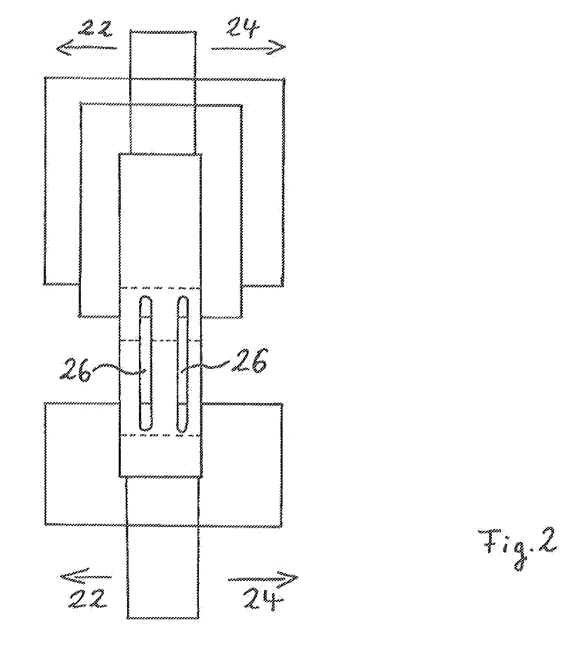

Foil 9 of Fig. 1 comprises a semi-transparent insulating material 9a containing at least one, preferably a plurality of conductive structures 10 (in Fig. 1 and 2 only one foil 9 and only one of the conductive structures 10 is shown), whereas the conductive structure 10 comprises four sections, a first section 10a, a second section 10b, a third section 10c, and a fourth section 10d with mutually different spatial orientations. The first section 10a extends on top of an on-chip contact pad 14 on the die 6 parallel to the pad 14. The second section 10b extends in an angle 16 upwards away from the top surface 8 of the die 6. The angle 16 is between 15 and 45 degrees, preferably between 20 and 45 degrees, more preferably about 41 degrees, with respect to the first section 10a, which in the embodiment of Fig. 1 corresponds to the angle between the second section 10b and the top surface 8 of the die 6.

The third section 10c extends downwards from the second section 10b and includes an angle 18 of between 80 and 150 degrees, preferably between 90 and 140 degrees, with respect to the second section 10b. With respect to the top surface 8 of the die 6 the third section 10c includes an angle 20 of between 20 and 60 degrees, preferably between 25 and 50 degrees, more preferably between 28 and 32 degrees.

The fourth section 10d extends again upwards and includes an angle 21 of between 20 and 60 degrees, preferably between 25 and 50 degrees, more preferably between 28 and 32 degrees with respect to the top surface 8 of the die 6.

In the depicted embodiment the conductive structure 10 is present on both sides of the insulating material 9. In an alternative (not shown) embodiment the conductive structure 10 is present only on one side of the insulating material 9.

The at least one conductive structure 10 is present as a conductive pattern in the form of a matrix. This is schematically shown in Fig. 2 by arrows 22 and 24 which indicate that the structure of Fig. 2 is repeatedly connected by using more of foil 9 to the depicted structure on both sides of the depicted structure as desired. As indicted in Fig. 2 in such extended structure 22, 24 the insulating material 9 and the conducting structure 10 is present as a series of mutually parallel strips 9, 10. In the conductive structure 10 mould assist holes 26 are provided in the foil 9, 10.

As shown in Fig. 1 the foil 9, 10 is deformed such that the conductive structure 10 extends in a direction substantially perpendicular to the plane of the undeformed foil 9, 10. The shown package 1 can be provided by a method for foil-based bonding, in particular for foil-based clip- and/or wire-bonding of a semiconductor device, comprising the steps of:
- using a foil for foil-based bonding, in particular for foil-based clip- and/or wire-bonding of a semiconductor device, the foil comprising an insulating material containing at least one conductive structure 10, and providing the conductive structure 10 with at least three sections 10a, 10b, 10c, 10d with mutually different spatial orientations.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality. A single item may fulfill the functions of several items recited in the claims. The mere fact that certain measures are recited in mutually different dependent claims does not indicate that a combination of these measures cannot be used to advantage.

A computer program may be stored/distributed on a suitable medium, such as an optical storage medium or a solid-state medium supplied together with or as part of other hardware, but may also be distributed in other forms, such as via the Internet or other wired or wireless telecommunication systems.

Any reference signs in the claims should not be construed as limiting the scope.

## Claims

1. Foil (9, 9a, 10) for foil-based bonding, in particular for foil-based clip- and/or wire-bonding of a semiconductor device, comprising an insulating material (9a) containing at least one conductive structure (10), whereas the conductive structure (10) comprises at least three sections (10a, 10b, 10c, 10d) with mutually different spatial orientations.

2. Foil (9, 9a, 10) as claimed in claim 1, **characterized in that** a first section (10a) of the at least three sections (10a, 10b, 10c, 10d) extends at least on top (8) of an on-chip contact pad (14) on a die (2) of the semiconductor device parallel to the pad (14).

3. Foil (9, 9a, 10) as claimed in any one of claims 1 or 2, **characterized in that** a second section (10b) of the at least three sections (10a, 10b, 10c, 10d) extends in an angle (16) upwards with respect to a first section (10a) of the at least three sections (10a, 10b, 10c, 10d), in particular upwards away from a top surface (8) of a die (2) of the semiconductor device.

4. Foil (9, 9a, 10) as claimed in any one of claims 1-3, **characterized in that** a second section (10b) of the at least three sections (10a, 10b, 10c, 10d) extends in an angle (16) upwards with respect to a first section (10a) of the at least three sections (10a, 10b, 10c, 10d), in particular upwards away from a top surface (8) of a die (2) of the semiconductor device, with an angle (16) of between 15 and 45 degrees, preferably between 20 and 45 degrees, more preferably about 41 degrees, with respect to the first section (10a), in particular with respect to a top surface (8) of a die (2) of the semiconductor device.

5. Foil (9, 9a, 10) as claimed in any one of claims 1-4, **characterized in that** a third section (10c) of the at least three sections (10a, 10b, 10c, 10d) extends downwards from a second section (10b) of the at least three sections (10a, 10b, 10c, 10d) and including an angle (18) of between 80 and 150 degrees, preferably between 90 and 140 degrees, with respect to the second section (10b).

6. Foil (9, 9a, 10) as claimed in any one of claims 1-5, **characterized in that** a third section (10c) of the at least three sections (10a, 10b, 10c, 10d) extends downwards from a second section (10b) of the at least three sections (10a, 10b, 10c, 10d) and including an angle (20) of between 20 and 60 degrees, preferably between 25 and 50 degrees, more preferably between 28 and 32 degrees, with respect to a top surface (8) of a die (2) of the semiconductor device.

7. Foil (9, 9a, 10) as claimed in any one of claims 1-6, **characterized in that** the conductive structure (10) is present only on one side of the insulating material (9a).

8. Foil (9, 9a, 10) as claimed in any one of claims 1 -7, **characterized in that** the at least one conducting structure (10) is present as a conductive pattern, preferably in the form of a matrix.

9. Foil (9, 9a, 10) as claimed in any one of claims 1-8, **characterized in that** the insulating material (9a) and/or the at least one conducting structure (10) is present as a series of mutually parallel strips.

10. Foil (9, 9a, 10) as claimed in any one of claims 1-9, **characterized in that**, preferably in the conductive structure (10), more preferably in at least one of said strips, mould assist holes (26) are provided in the foil (9, 9a, 10).

11. Foil (9, 9a, 10) as claimed in any one of claims 1-10, **characterized in that** the foil (9, 9a, 10) is deformed such that the conductive structure (10) extends in a direction substantially perpendicular to the plane of the undeformed foil (9, 9a, 10).

12. Method for foil-based bonding, in particular for foil-based clip- and/or wire-bonding of a semiconductor device, comprising the steps of:
- using a foil (9, 9a, 10) for foil-based bonding, in particular for foil-based clip- and/or wire-bonding of a semiconductor device, the foil (9, 9a, 10) comprising an insulating material (9a) containing at least one conductive structure (10), and
providing the conductive structure (10) with at least three sections (10a, 10b, 10c, 10d) with mutually different spatial orientations.

13. Method as claimed in claim 12, comprising the steps of:
- providing the conductive structure (10) with at least three sections (10a, 10b, 10c, 10d) with mutually different spatial orientations in a way to reach a foil (9, 9a, 10) as claimed in any one of claims 1-11.

14. Package (1) in which a semiconductor device is bonded by foil-based bonding, in particular by foil-based clip- and/or wire-bonding of the semiconductor device, comprising a die (2) attached to a first carrier (4) with its first side (6), and attached with its second side (8) to a second carrier (9, 9a, 10), the second carrier comprising a foil (9, 9a, 10) for foil-based bonding, in particular for foil-based clip- and/or wire-bonding of a semiconductor device, and the first (4) and second carrier (9, 9a, 10) are mutually connected, such that a thermal and/or electrical current may flow from the second side (8) of the die (2) to any pad (11) in the first carrier (4), whereas the die (2) and the first (4) and the second (9, 9a, 10) carrier are encapsulated at least partially, **characterized in that** the foil (9, 9a, 10) is a foil (9, 9a, 10) according to any one of claims 1-11.

## Amended claims

### Amended claims in accordance with Rule 137(2) EPC.

**1.** Foil (9, 9a, 10) for foil-based bonding comprising an insulating material (9a) containing at least one conductive structure (10), and **characterised in that** the conductive structure (10) comprises at least two bends such that, when the foil is bonded to a semiconductor device, a first section (10b) of the conductive structure between the two bends extends upwardly from the semiconductor device.

**2.** Foil (9, 9a, 10) as claimed in claim 1, **characterized in that** the first section (10b) of the conducive structure is adapted to extend in an angle (16) of between 15 and 45 degrees with respect to a top surface (8) of the semiconductor device when the foil is bonded to the semiconductor device.

**3.** Foil (9, 9a, 10) as claimed in any one of claims 1-2, **characterized in that** a second section (10c) of the conductive structure adajcent the first sectionis adapted to extend downwards from the first section (10b) at an angle (18) of between 80 and 150 degrees with respect to the first section (10b) when the foil is bonded to the semiconductor device.

**4.** Foil (9, 9a, 10) as claimed in any one of claims 1-3, **characterized in that** a second section (10c) of the conductive structure adajcent the first section (10b) is adapted to extend downwards from the first section (10b)at an angle (20) of between 20 and 60 degrees with respect to a top surface (8) of the semiconductor device when the foil is bonded to the semiconductor device.

**5.** Foil (9, 9a, 10) as claimed in any one of claims 1-4, **characterized in that** the conductive structure (10) is present only on one side of the insulating material (9a),

**6.** Foil (9, 9a, 10) as claimed in any one of claims 1-5, **characterized in that** the at least one conducting structure (10) is present as a conductive pattern, preferably in the form of a matrix.

**7.** Foil (9, 9a, 10) as claimed in any one of claims 1-6, **characterized in that** the insulating material (9a) and/or the at least one conducting structure (10) is present as a series of mutually parallel strips.

**8.** Foil (9, 9a, 10) as claimed in any one of claims 1-7, **characterized in that** the foil (9, 9a, 10) is deformed such that the conductive structure (10) extends in a direction substantially perpendicular to the plane of the undeformed foil (9, 9a, 10).

**9.** Method for foil-based bonding comprising the step of:
∼ using a foil (9, 9a, 10) for foil-based bonding, the foil (9, 9a, 10) comprising an insulating material (9a) containing at least one conductive structure (10), and **characterised by** further comprising the step of providing the conductive structure (10) with two bends such that, when the foil is bonded to a semiconductor device, a first section (10b) of the conductive structure between the two bends extends upwardly from the semiconductor device.

**10.** Package (1) in which a semiconductor device is bonded by foil-based bonding, comprising a die (2) attached to a first carrier (4) with its first side (6), and attached with its second side (8) to a second carrier (9, 9a, 10), the second carrier comprising a foil (9, 9a, 10) for foil-based bonding and wherein the first (4) and second carrier (9, 9a, 10) are mutually connected, such that a thermal and/or electrical current may flow from the second side (8) of the die (2) to any pad (11) in the first carrier (4), whereas the die (2) and the first (4) and the second (9, 9a, 10) carrier are encapsulated at least partially, **characterized in that** the foil (9, 9a, 10) is a foil (9, 9a, 10) according to anyone of claims 1-8.
